# EUROPEAN PATENT APPLICATION

(11) **EP 2 063 259 A1**
(43) Date of publication of application: **27.05.2009**
(21) Application number: 07793009.7
(22) Date of filing: 27.08.2007
(51) Int. Cl.: G01N 21/956, G06T 1/00, H05K 13/08

(54) **METHOD FOR INSPECTING MOUNTING STATUS OF ELECTRONIC COMPONENT**

(30) Priority: 13.09.2006 JP 2006247554
(71) Applicant: Towa Corporation, Kyoto-shi, Kyoto 601-8105 (JP)
(72) Inventor: KATAGIRI, Yo, Kyoto-shi, Kyoto 601-8105 (JP)
(74) Representative: Willett, Christopher David
(86) International application number: PCT/JP2007/066532
(87) International publication number: WO 2008/032553

(57) **Abstract**

An image information of a substrate (1) on which a plurality of electronic components (2) are to be mounted is obtained. Next, the image information is binarized by using a predetermined threshold value (TH1), so that binary data are acquired. Then, a tentative presence region recognized as corresponding to the electronic component (2) is acquired on the basis of the binary data. Further, a new threshold value (TH2) is set by changing the predetermined threshold value (TH1). Next, new binary data are acquired by using the new threshold value (TH2). Thereby, a new tentative presence region is acquired. Then, the new tentative presence region is combined with the just preceding tentative presence region. Then, a new threshold value (TH3) is set. A series of above described steps are repeated until all detection results of individual chips (2) indicating whether or not each of the plurality of chips is mounted at a predetermined position, are prepared.

## Description

### TECHNICAL FIELD

The present invention relates to a method of inspecting mounting states of electronic components, for inspecting whether or not a plurality of electronic components to be mounted at predetermined positions on a circuit substrate are actually mounted at the predetermined positions.

### BACKGROUND ART

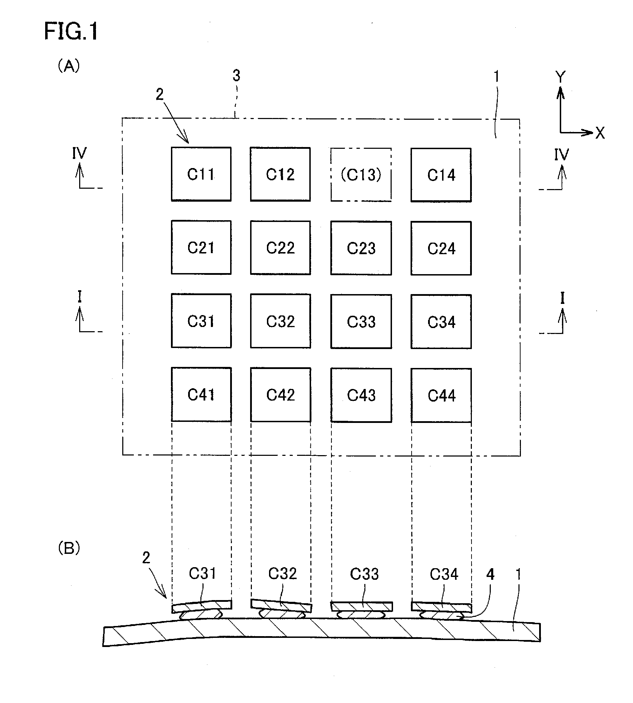

With reference to Fig. 1, there is explained a conventional method of inspecting mounting states of a plurality of electronic components mounted on a circuit substrate (hereinafter referred to as "substrate"), such as a printed substrate or a lead frame. Fig. 1 (A) is a plan view showing an image of a plurality of electronic components mounted on a substrate, and Fig. 1 (B) is a sectional view along the line I-I in Fig. 1(A), showing mounting states of the electronic components. Note that any figure used in the specification is schematically illustrated by being properly omitted and exaggerated for the sake of brevity of description.

In the following, there is explained a method of inspecting mounting states of electronic components in the case where chip-like electronic components are respectively mounted in a plurality of matrix-shaped regions specified by grid-shaped virtual lines drawn on the substrate. Here, the chip-like electronic component is a semiconductor chip, a chip capacitor or the like (hereinafter referred to as "chip"), which has an upper surface formed by a mirror surface or a surface similar to the mirror surface. Note that after the chips mounted on the substrate are collectively or individually resin-sealed by a sealing resin, a molded object including the substrate, the chips and the sealing resin is cut for the each region, so that a package as a product is completed.

As shown in Fig. 1(A), there is obtained an image of a plurality of chips 2 mounted on a substrate 1. This image is obtained from reflected light received from substrate 1, when substrate 1 in a visual field 3 is photographed by using an illumination and a camera provided above substrate 1. Plurality of chips 2, such as chips C11, C12, ..., C43 and C44, are die-bonded onto substrate 1 by an adhesion member 4 (see Fig. 1(B)) made of a paste, an adhesion film, or the like, in a state of being arranged in a matrix of 4 rows and 4 columns. Further, electrodes (both not shown) of substrate 1 and chips 2 are electrically connected with each other by wires (not shown) (wire bonding). Thereafter, plurality of chips are collectively resin-sealed.

Here, the mounting states of chips 2 before the resin sealing are inspected by processing the image information of plurality of chips 2 mounted on substrate 1. As a first inspection method, there is proposed a method for detecting whether or not respective chips 2 are mounted on substrate 1, on the basis of binary data obtained by binarizing the image information by using a predetermined threshold value. As a second method, there is proposed a method in which every time each chip is mounted (attached) on the wiring substrate, the presence and the posture of the chip are recognized in real time by a difference processing between images before and after the mounting of the chip (see, for example, Patent Document 1). In this method, a sensor consisting of a light projector and a light receiver is arranged obliquely above a chip mounting planned portion.

However, according to the above described prior art, there arises the following problems. The problem arises when there are differences in luminance between light beams reflected by chips 2 in the image of plurality of chips 2 mounted on substrate 1. The differences in luminance result from the fact that variation in the reflected light beams received from respective chips 2 is caused by a difference in the inclination degree between respective chips 2 due to variation in the thickness of adhesion member 4, and by warpage, waving or the like in substrate 1. When there are differences in luminance between the light beams reflected by chips 2, in the first conventional method, the relation between the image and the presence of chip 2 is made unclear in the binary data obtained by the binarization using the predetermined threshold value. Therefore, there arises a problem that it is difficult to highly accurately detect whether or not respective chips 2 are mounted on substrate 1. Further, in the second conventional method, when chip 2 is inclined, the relation between the image and the presence of chip 2 is made unclear in the binary data obtained by the binarization using the predetermined threshold value, in dependence upon the way of illumination from the light projector provided obliquely above chip 2. Therefore, there arises a problem that it is difficult to detect whether or not respective chips 2 are mounted on substrate 1. In addition, since the presence and the posture of chip 2 are recognized every time each chip 2 is mounted on substrate 1, when a number of chips 2 are mounted on substrate 1, there arises a problem that it takes much time to inspect the mounting states of chips 2.

Here, the following means may be used to solve the above described problems. The first means is a shading correction. However, the shading correction is useful for detecting differences in luminance between light beams reflected by a plurality of portions in a large region, such as for detecting variation in illuminance distribution of illumination light, but is not useful for detecting differences in luminance of light beams reflected by a plurality of portions in a small region such as a region where chip 2 is used as a unit. The second means is, for example, a dynamic threshold method such as a dynthresh method. However, even when the dynamic threshold method is used, it may not be possible to detect a chip in cases such as where the inclination of the substrate and the inclination of the chip are different from each other, and where the chips are scatteringly inclined to each other. Therefore, it cannot be said that the dynamic threshold method is always useful.
Patent Document 1: Japanese Patent Laying-Open No. 2003-296733 (page 2, Fig. 1)

### DISCLOSURE OF THE INVENTION

### PROBLEMS TO BE SOLVED BY THE INVENTION

An object of the present invention is to provide a method of inspecting mounting states of electronic components, capable of easily and accurately obtaining in a short time all of detection results of individual electronic components, indicating whether or not each of a plurality of electronic components to be mounted at predetermined positions on a substrate is actually mounted at the predetermined position.

### MEANS FOR SOLVING THE PROBLEMS

In order to solve the above described problems, a method of inspecting mounting states of electronic components according to an aspect of the present invention, is a method of inspecting mounting states of electronic components, for inspecting whether or not each of a plurality of electronic components to be mounted at predetermined positions on a substrate is actually mounted at the predetermined position.

In this method, there are performed the following steps of:
obtaining image information of a substrate on which a plurality of electronic components are to be mounted;
obtaining binary data by binarizing the image information by using a predetermined threshold value;
obtaining a tentative presence region recognized as corresponding to the electronic component on the basis of the binary data;
setting a new threshold value by changing the predetermined threshold value;
obtaining new binary data by binarizing the image information by using the new threshold value;
setting the new binary data as the binary data in the step of obtaining a tentative presence region;
obtaining new tentative presence regions recognized as corresponding to the plurality of electronic components on the basis of the new binary data; and
combining the new tentative presence regions with the tentative presence region.

Further, in the present method, a loop having the step of setting a new threshold value, the step of obtaining new binary data, the step of setting new binary data, the step of obtaining new tentative presence regions, and the step of combining the new tentative presence regions, is repeated by a predetermined number of times.

Thereby, in an image of a plurality of electronic components mounted on a substrate, even in the case where there are differences in luminance between light beams reflected from the electronic components, it is possible to obtain all of detection results of the individual electronic components, indicating whether or not each of the plurality of electronic components is actually mounted at a predetermined position, by using each of a plurality of threshold values (TH1 to TH4). Further, in the case where a number of electronic components are mounted on a substrate, it is possible to complete an inspection of mounting states of the electronic components in a shorter time as compared with a method for recognizing the presence and the posture of the electronic components on the substrate every time each of the electronic components is mounted at a predetermined position.

Further, a method of inspecting mounting states of electronic components according to another aspect of the present invention, is a method of inspecting mounting states of electronic components, for inspecting whether or not each of a plurality of electronic components to be mounted at predetermined positions on a substrate is actually mounted at the predetermined position.

In this method, there are performed the following steps of:
obtaining image information of a substrate on which a plurality of electronic components are to be mounted;
obtaining binary data by binarizing the image information by using a predetermined threshold value;
obtaining a tentative presence region recognized as corresponding to the electronic component on the basis of the binary data;
setting a new threshold value by changing the predetermined threshold value;
obtaining new binary data by binarizing the image information by using the new threshold value;
setting the new binary data as the binary data in the step of obtaining a tentative presence region;
obtaining new tentative presence regions recognized as corresponding to the plurality of electronic components on the basis of the new binary data; and
combining the new tentative presence regions with the tentative presence region.

Further, in the present method, the step of setting a new threshold value, the step of obtaining new binary data, the step of setting new binary data, the step of obtaining new tentative presence regions, and the step of combining the new tentative existence regions, are repeated until all of detection results of individual chips indicating whether or not each of the plurality of electronic components is mounted at the predetermined position are prepared.

Further, in the method of inspecting mounting states of electronic components according to the present invention, in the above described inspection methods, a new threshold value is set by increasing or decreasing the threshold value by a predetermined amount in the step of setting a new threshold value.

The foregoing and other objects, features, aspects and advantages of the present invention will become more apparent from the following detailed description of the present invention, when taken in conjunction with the accompanying drawings.

### BRIEF DESCRIPTION OF THE DRAWINGS

Fig. 1(A) is a plan view showing an image of a plurality of electronic components mounted on a substrate;
Fig. 1(B) is a sectional view along the line I-I in Fig. 1(A), showing mounting states of the electronic components;
Fig. 2(A) is a sectional view along the line I-I in Fig. 1, showing mounting states of chips;
Fig. 2(B) is a figure showing a luminance distribution along the line I-I in Fig. 1;
Fig. 2(C) is a figure showing detection results of the respective chips in the case where image processing is performed by using four kinds of different threshold values on the basis of the luminance distribution;
Fig. 3(A) is a sectional view along the line I-I in Fig. 1, showing mounting states of chips;
Fig. 3(B) is a figure showing a luminance distribution along the line I-I in Fig. 1;
Fig. 3(C) is a figure showing the way the respective chips are viewed in the case where the image processing is performed by using four kinds of different threshold values based on the luminance distribution;
Fig. 4(A) is a sectional view along the line IV-IV in Fig. 1, showing mounting states of chips;
Fig. 4(B) is a figure showing a luminance distribution along the line IV-IV in Fig. 1;
Fig. 4(C) is a figure showing detection results of the respective chips in the case where the image processing is performed by using four kinds of different threshold values on the basis of the luminance distribution;
Fig. 5 is a flow chart showing a method of inspecting mounting states of electronic components performed by a computer, according to Embodiment 1;
Fig. 6 is a flow chart showing a method of inspecting mounting states of electronic components performed by the computer, according to Embodiment 2; and
Fig. 7 is a figure showing a relation of the computer which perform the processing in the flow charts shown in Fig. 5 and Fig. 6, to a camera and an illuminator.

### DESCRIPTION OF THE REFERENCE SIGNS

1 substrate, 2 chip (electronic component), 3 visual field, 4 adhesion member, C11 to C44 chip (electronic component).

### BEST MODES FOR CARRYING OUT THE INVENTION

### [Embodiment 1]

Embodiment 1 of a method of inspecting mounting states of electronic components according to the present invention will be explained with reference to Fig. 1 to Fig. 5, and Fig. 7.

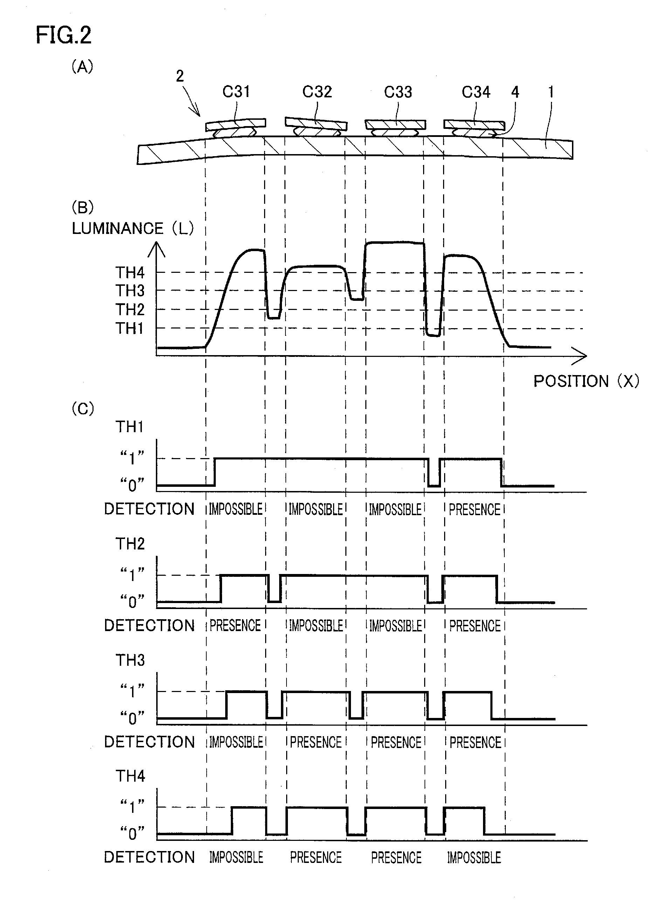

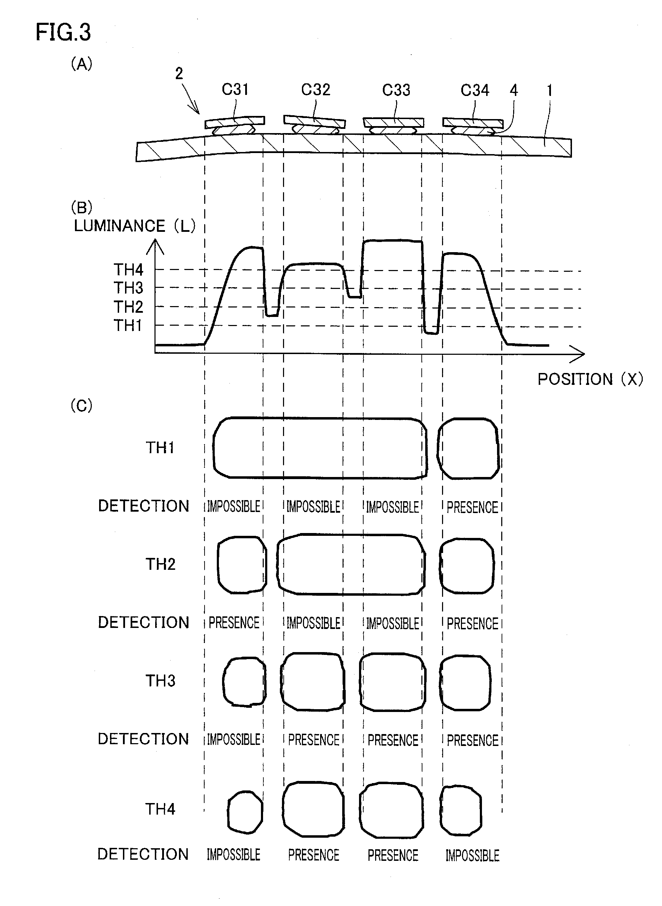

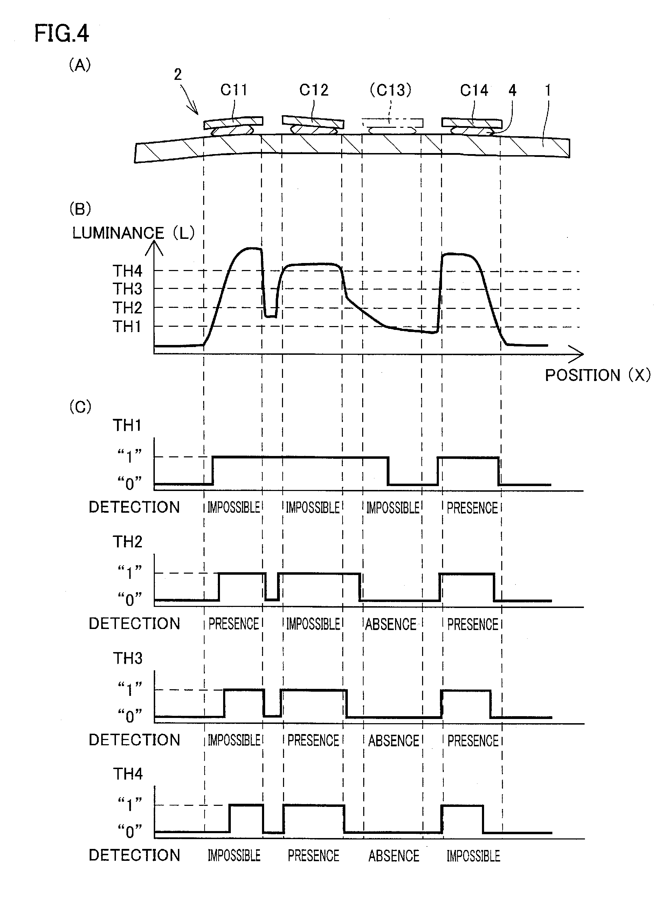

Note that the detection results of respective chips in Fig. 2(C) and Fig. 4(C) are expressed by a signal level "0" or "1". The signal level "1" indicates that "the presence of reflected light" is detected when a threshold value is used. Further, the detection results shown in the first stage to the fourth stage in Fig. 3(C), indicate the presence or absence of the chips for one row along the line I-I in Fig. 1(A), when each of four kinds of different threshold values is used. Actually, due to the influence of the reflected light beams received from chips 2 adjacent with each other in the Y direction, each chip 2 may appear as being made wider in the Y direction or as being joined with the adjacent chip in the Y direction.

In Fig. 1(B), Fig. 2(A), Fig. 3(A) and Fig. 4(A), there are respectively shown states in which in the image of plurality of chips 2 mounted on substrate 1, there are differences in luminance between the regions where chips 2 are to be mounted on substrate 1. In the states shown in these figures, there are the following problems in comparison with an ideal state in which chips 2 are horizontally mounted on the flat main surface of substrate 1. Note that the mounting state of chip C33 shown in Fig. 1(B), Fig. 2(A) and Fig. 3(A) corresponds to the ideal state in which chip 2 is mounted on substrate 1.

The first problem is that chip C32 in Fig. 1(B), Fig. 2(A) and Fig. 3(A) and chip 12 in Fig. 4(A) are mounted in an inclined state with respect to the main surface of substrate 1. The second problem is that substrate 1 is warped so as to be convex in the central portion, as shown in Fig. 1(B), Fig. 2(A), Fig. 3(A) and Fig. 4(A). Specifically, on the outside from near the center of chip 2 (chips C31 and C11) in the leftmost column, substrate 1 is greatly deformed so as to be lowered more greatly toward the outside. Further, on the outside from near the left end of chip 2 (chips C34 and C14) in the rightmost column, substrate 1 is slightly deformed so as to be positioned on the lower side toward the outside. The third problem is that chip C13 to be mounted on the predetermined position is not mounted, as shown in Fig. 1(A) and Fig. 4(A).

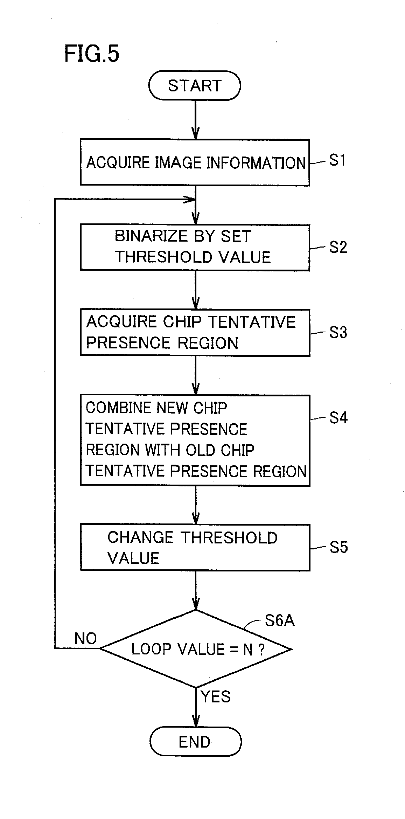

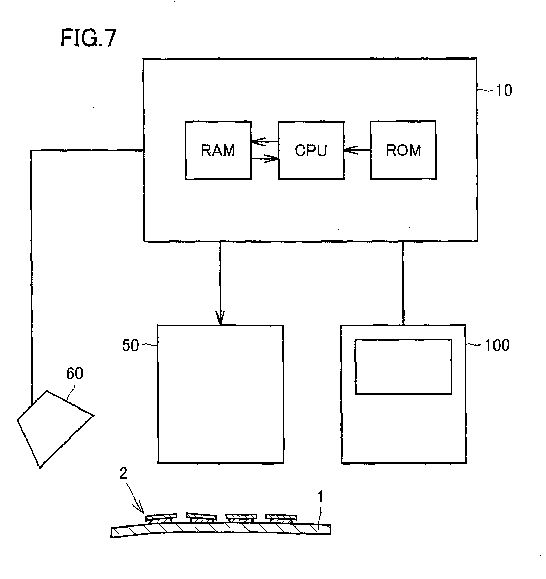

In the present embodiment, whether or not each of plurality of chips 2 to be mounted at predetermined positions on substrate 1 is mounted at the predetermined position is inspected by performing image processing on the basis of the image shown in Fig. 1(A). First, in step S1 in Fig. 5, a command signal is transmitted to a camera 50 and an illuminator 60, as shown in Fig. 7. Thereby, a light beam is emitted from illuminator 60. The emitted light beam is reflected by substrate 1 and chips 2. The reflected light beams are acquired by camera 50. Thereby, image information of plurality of chips 2 mounted on substrate 1 is acquired by camera 50. The image information acquired by camera 50 includes the luminance distribution shown in Fig. 2(B) and Fig. 3(B) and the luminance distribution shown in Fig. 4(B). Note that the image information is once inputted into a RAM (Random Access Memory) of a computer 10 shown in Fig. 7 from camera 50. Computer 10 which is a general type has a ROM (Read Only Memory), CPU (Central Processing Unit), and the like. Further, computer 10 shown in Fig. 7 outputs a detection result of the presence of chips 2 at the predetermined positions on substrate 1 and a determination result of whether or not all the chips of a product are mounted at the predetermined positions, to a display device 100 shown in Fig. 7, and display device 100 displays the results on a screen. Therefore, it is possible for an operator to recognize the inspection result of the mounting states of electronic components by viewing the screen of display device 100 shown in Fig. 7.

Next, in step S2 in Fig. 5, computer 10 calculates a threshold value TH1 on the basis of a gray value in the image information by using a program stored in the ROM and a calculation function of the CPU. Further, the CPU binarizes the image information stored in the RAM by using threshold value TH1. Thereby, binary data based on the image information are acquired. The acquired binary data are temporarily stored in the RAM. In the following, it is assumed that in any embodiment, various data, threshold values and extracted regions are temporarily stored in the RAM of computer 10, and various arithmetic processings such as binarization are performed by the CPU. First, in the present embodiment, binary data are acquired by using lowest threshold value TH1 among four threshold values TH1 to TH4 shown in Fig. 2(B) and Fig. 3(B). Note that in the present embodiment, the threshold values adjacent to each other among four threshold values TH1 to TH4 arranged in this order have a difference (equal difference) of a predetermined step value. Further, in the present embodiment, the image information is binarized by using all threshold values TH1 to TH4. Here, instead of calculating threshold value TH1 on the basis of the gray value, a predetermined lowest threshold value, which is stored in the ROM, may also be used as threshold value TH1.

Next, in step S3 in Fig. 5, the CPU performs segmentation of the binary data which are acquired in step S2 and temporarily stored in the RAM, and thereby makes a plurality of regions extracted and stored in the RAM. As shown in the uppermost stage in Fig. 2(C), when threshold value TH1 is used, all the three chips of chips C31 to C33 are included in a large region of signal level "1", while signal level "1" is indicated in a region approximately corresponding to the size of chip C34. As shown in the uppermost stage in Fig. 3(C), if a person views the image grasped by the CPU, these mean that the person can view one bright image approximately corresponding to the whole region in which chips C31 to C33 are to be mounted, and one bright image approximately corresponding to the size of chip 34 in the region in which chip C34 is to be mounted.

Further, in step S3, the plurality of extracted regions (the region corresponding to chips C31 to C33, and the region corresponding to chip C34) are divided into regions (hereinafter referred to as "the chip tentative presence regions") that it is recognized by the CPU that chips 2 are mounted on substrate 1, and regions recognized by the CPU as other than the chip tentative presence regions. This division is performed for the plurality of regions extracted by the segmentation, by using height (in the Y direction in Fig. 1), width (in the X direction in Fig. 1), a shape factor, and the like. Thereby, the region corresponding to chip C34 can be acquired as a chip tentative presence region. This means that it was recognized by the CPU that chip C34 is mounted at a predetermined position, in other words, that the CPU detected that chip C34 is mounted at the predetermined position.

Here, in Fig. 2 to Fig. 4, it is expressed by a term "impossible" that "whether or not a chip is mounted at a predetermined position cannot be detected". On the other hand, in Fig. 2 to Fig. 4, it is expressed by a term "presence" that "a chip is mounted at a predetermined position", and it is expressed by a term "absence" that "a chip is not mounted at a predetermined position". Further, the term of "impossible" means that "it is impossible to decide whether or not a chip is mounted at a predetermined position", and may be replace by a term of "undecided". Further, the term of "impossible" means that "it is impossible to determine whether or not a chip is mounted at a predetermined position", and may be replace by a term of "unknown".

Next, in step S4 in Fig. 5, the chip tentative presence region acquired in step S3, is combined with the just preceding chip tentative presence region (hereinafter referred to as "the old chip tentative presence region") among the already acquired chip tentative presence regions, by the CPU in the RAM, so that a new chip tentative presence region is acquired in the RAM. This new chip tentative presence region includes all the regions that it is recognized by the CPU that a chip is mounted on the substrate, that is, the chip tentative presence regions acquired up to this time. Note that in step S4 at this time, no old chip tentative presence region exists, and hence the region corresponding to chip C34 is acquired as it is as the new chip tentative presence region in the RAM.

Next, in step S5 in Fig. 5, the threshold value is changed by the CPU, so that a new threshold value is set in the RAM. Specifically, lowest threshold value TH1 among threshold values TH1 to TH4 shown in Fig. 2(B) and Fig. 3(B) is changed to second lowest threshold value TH2.

Next, in step S6A in Fig. 5, it is determined by the CPU whether or not the number of times of the loop has reached a predetermined number of times (N times). In the present embodiment, the image information is binarized by using all of four threshold values TH1 to TH4, and hence the predetermined number of times N is set to 3. Further, at the time point when threshold value TH1 is changed to threshold value TH2, the number of times of the loop is zero, and hence after it is recognized by the CPU that the number of times of the loop is not three, the processing in step S2 is performed.

Next, in step S2 (second time) in Fig. 5, the image information previously acquired in step S1 is binarized by the CPU by using changed threshold value TH2. Thereby, new binary data based on the image information are acquired in the RAM.

Next, in step S3 (second time) in Fig. 5, new binary data acquired in step S2 (second time) are set as binary data in the RAM. A plurality of regions are extracted in the RAM by performing segmentation of the new binary data. As shown in the second stage from the top in Fig. 2(C), when threshold value TH2 is used, both two chips C32 and C33 are included in a large region of signal level "1". On the other hand, signal level "1" is indicated in two regions approximately corresponding to the regions in which chips C31 and C34 are to be mounted, respectively. As shown in the second stage from the top in Fig. 3(C), these mean that if the image grasped by the CPU is viewed by a person, the following image is viewed. The image is viewed as a combination of one bright image approximately corresponding to the whole of the regions in which chips C32 and C33 are to be mounted, and two bright images approximately corresponding to the sizes of chips C31 and C34, respectively, in regions in which chips C31 and C34 are to be mounted.

Further, in step S3 (second time), the plurality of extracted regions (two regions respectively corresponding to chips C31 and C34, and one region corresponding to chips C32 and C33 as a whole) are divided into chip tentative presence regions and a region other than the chip tentative presence regions by the CPU. Thereby, it is possible to acquire the two regions respectively corresponding to chips C31 and C34 as new chip tentative presence regions in the RAM. This means that it was recognized by the CPU that chips C31 and C34 are mounted at predetermined positions, in other words, that the CPU detected that chips C31 and C34 are mounted at the predetermined positions.

Next, in step S4 (second time) in Fig. 5, the chip tentative presence regions acquired in step S3 (second time) are combined with the old chip tentative presence region in the RAM, so that a new chip tentative presence region is acquired. This new chip tentative presence region includes all the regions that it was recognized by the CPU that the chip is mounted on the substrate, that is, all the chip tentative presence regions acquired in the RAM up to this time. Note that in step S4 (second time) at this time, the region corresponding to chip C34 exists as the old chip tentative presence region. Therefore, the regions corresponding to chip C31 and C34 are acquired as the new chip tentative presence region.

Next, in step S5 (second time) in Fig. 5, the threshold value is changed by the CPU, so that a new threshold value is set in the RAM. Specifically, second lowest threshold value TH2 among threshold values TH1 to TH4 shown in Fig. 2(B) and Fig. 3(B) is changed to third lowest threshold value TH3.

Next, in step S6A (second time) in Fig. 5, it is determined whether or not the number of times of the loop has reached a predetermined number of times N (N=3). At the time point when threshold value TH2 is changed to threshold value TH3, since the number of times of the loop is one, after it is determined by the CPU that the number of times of the loop is not three, the processing in step S2 is performed. In step S2 (third time), threshold value TH3 is used.

Subsequently, the loop from step S2 to step S6A shown in Fig. 5 is repeated until the number of times of the loop becomes three. In the case where the number of times of the loop is one as described above, and where the processing in step S2 (third time) is performed again, threshold value TH3 is used. In this case, in step S3 (third time), as shown in the third stage from the top in Fig. 3(C), the image of chip C31 becomes too small, so that it is impossible for the CPU to detect chip C31. On the other hand, the CPU is capable of continuously detecting chip C34 as chip 2 mounted on substrate 1, and further becomes capable of detecting that chips C32 and C33 are mounted on substrate 1. Further, the regions corresponding to chip C31 and C34 exist as the old chip tentative presence regions. Therefore, in step S4 (third time), the chip tentative presence regions corresponding to chips C32, C33 and C34 are combined with the old chip tentative presence regions corresponding to chips C31 and C34 in the RAM. Thereby, the regions corresponding to chips C31 to C34 are acquired as chip tentative presence regions in the RAM. This means that it was determined by the CPU that chips C31 to C34 are mounted at predetermined positions, in other words, that it was detected by the CPU that chips C31 to C34 are mounted at the predetermined positions. That is, in step S4 (third time) using threshold value TH3, it is detected that all chips C31 to C34 are mounted at the predetermined positions.

Further, in the case where the number of times of the loop is 2 times, and where the processing in step S2 (fourth time) is performed again, threshold value TH4 is used. In this case, in step S3 (fourth time), as shown in the fourth stage from the top in Fig. 3(C), the image of chip C34 becomes too small in addition to chip C31, so that it becomes impossible for the CPU to detect chip 34 in addition to chip 31. On the other hand, it is possible for the CPU to continuously detect that chips C32 and C33 are mounted on substrate 1. In this case, in step S4 (fourth time), the old chip tentative presence regions corresponding to chips C31 to C34 are combined with the new chip tentative presence regions corresponding to chips C32 and C33 in the RAM. Therefore, the already acquired chip tentative presence regions (the regions corresponding to chips C31 to C34) are not affected by the fact that the CPU becomes incapable of detecting that chips C31 and C34 are mounted on substrate 1.

Next, with reference to Fig. 4, there is explained an inspection method in the case where an unmounted chip exists among plurality of chips 2 to be mounted on substrate 1. In the present embodiment, chip C13 is not mounted on substrate 1, as shown in Fig. 1(A) and Fig. 4. Further, in the present embodiment, as described above, the chip tentative presence regions are acquired by successively using threshold values TH1 to TH4 in the loop from step S2 to step S6A shown in Fig. 5. In the following, there are explained detection results of respective chips 2 in the case where each of threshold values TH1 to TH4 is used.

First, as shown in the uppermost stage in Fig. 4(C), when threshold value TH1 is used, it is possible to detect that chip 14 is mounted on substrate 1. Further, two chips C11 and C12 are included in a large region of signal level "1". Therefore, it is impossible to detect that the two chips are mounted on substrate 1. Further, if the image recognized by the CPU is viewed by a person, in the region in which chip C13 is to be mounted, due to an effect of inclined chip C12, the left half is brightly viewed, but the left-hand side of chip C14 between the left edge portion of chip C14 and the surface of substrate 1 is very brightly viewed as compared with the right-hand side of chip C14. Thereby, in the region in which chip C13 is to be mounted, the signal level of the left-hand side becomes "1" and the signal level of the right-hand side becomes "0". Therefore, it is impossible to detect whether or not chip C13 is mounted on substrate 1. Thereby, when threshold value TH1 is used, it is possible to acquire a region corresponding to chip C14 as a chip tentative presence region.

Next, as shown in the second stage from the top in Fig. 4(C), when threshold value TH2 is used, it is possible to detect that chip 11 is mounted in addition to chip C14. Further, the signal level of the large region including chip C12 is "1". Therefore, it is impossible to detect chip C12. Further, in the region in which chip C13 is to be mounted, the signal level is "0". Therefore, it is possible to detect that chip C13 is not mounted on substrate 1. Thereby, when threshold value TH2 is used, it is possible to acquire regions corresponding to chips C11 and C14 as chip tentative presence regions in the RAM. The chip tentative presence regions corresponding to chips C11 and C14 are combined with the old chip tentative presence region corresponding to chip C14 in the RAM. This makes it possible to acquire the new chip tentative presence regions corresponding to chips C11 and C14. Further, when threshold value TH2 is used, it is possible to acquire the region corresponding to chip C13 as a region (hereinafter referred to as "chip tentative absence region") that it is recognized that a chip is not mounted on the substrate. Therefore, when threshold value TH2 is used, it is possible for the CPU to detect that chips C11 and C14 are mounted on substrate 1, and that chip C13 is not mounted on substrate 1.

Next, as shown in the third stage from the top in Fig. 4(C), when threshold value TH3 is used, it is possible to detect that chip 12 is mounted on substrate 1 in addition to chip C14. Further, the image of chip C11 becomes too small, so that it becomes impossible for the CPU to detect chip C11. Further, it is continuously detected that chip C13 is not mounted on substrate 1. Thereby, when threshold value TH3 is used, it is possible for the CPU to acquire the regions corresponding to chips C12 and C14 as chip tentative presence regions. Next, the chip tentative presence regions corresponding to chips C12 and C14 are combined with the old chip tentative presence regions corresponding to chips C11 and C14 in the RAM. Thereby, it is possible to acquire new chip tentative presence regions corresponding to chips C11, C12 and C14. Further, there is no change about the region corresponding to chip C13 acquired as the chip tentative absence region. Therefore, when threshold value TH3 is used, all the detection results of individual chips 2 indicating whether or not each of chips C11 to C14 is mounted at the predetermined position are prepared.

Next, as shown in the fourth stage from the top in Fig. 4(C), when threshold value TH4 is used, it is possible to continuously detect that chip C12 is mounted. On the other hand, the image of chip C14 becomes too small in addition to chip 11, so that it becomes impossible to detect chip 14. Next, the chip tentative presence region corresponding to chip C12 is combined with the old chip tentative presence regions corresponding to chips C11, C12 and C14 in the RAM. Further, there is no change about the region corresponding to chip C13 acquired as the chip tentative absence region. Therefore, after all the detection results of individual chips 2 indicating whether or not each of chips C11 to C14 is mounted at the predetermined position are prepared by using threshold value TH3, the final detection results of individual chips 2 are not affected by the chip tentative presence region acquired by using threshold value TH4.

As explained above, according to the present embodiment, first, image information of plurality of chips 2 mounted on substrate 1 is acquired. Next, chip tentative presence regions are acquired by successively using plurality of threshold values TH1 to TH4 among which adjacent threshold values are different from each other by a predetermined step value. Thereafter, the chip tentative presence region is combined with the old chip tentative presence region. Thereby, in the image of plurality of chips 2 mounted on substrate 1, even in the case where there are differences in luminance between light beams reflected by chips 2, when at least one of plurality of threshold values TH1 to TH4 is used, it is possible to detect whether or not each chip 2 is mounted on substrate 1. Therefore, it is possible to detect whether or not each of chips 2 is mounted at a predetermined position, by combining the new chip tentative presence region with the old chip tentative presence region. Further, even when a number of chips 2 are mounted on substrate 1, it is possible to inspect the mounting states of chips 2 in a short time, as compared with a method in which the presence and the posture of each chip 2 are recognized every time each chip 2 is mounted on substrate 1.

### [Embodiment 2]

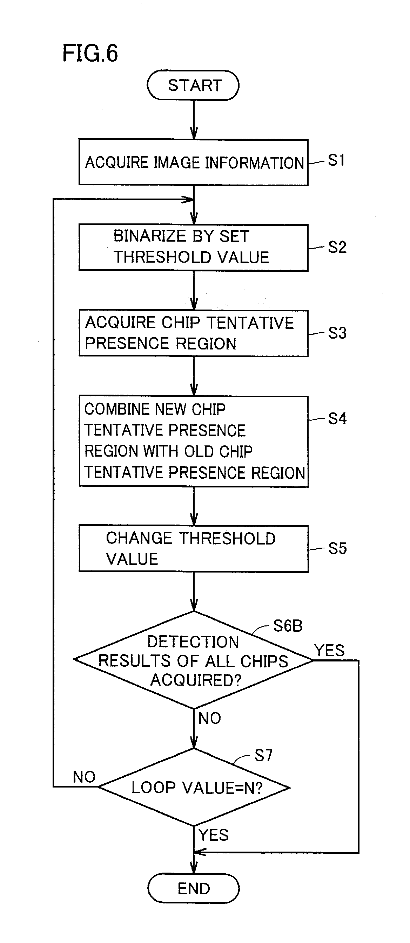

A method of inspecting mounting states of electronic components according to Embodiment 2 of the present invention will be explained with reference to Fig. 2, Fig. 4, Fig. 6 and Fig. 7. Fig. 6 is a flow chart showing the method of inspecting mounting states of electronic components, according to the present embodiment. In Embodiment 1, the processing in the loop from step S2 to step S6A shown in Fig. 5 is repeatedly performed until the number of times of the loop reaches a predetermined number of times. On the other hand, the inspection method according to the present embodiment is **characterized in that** a loop including steps from S2 to step S6B shown in Fig. 6 is repeated until all detection results of individual chips 2 indicating whether or not each of plurality of chips 2 is mounted at a predetermined position are prepared. Note that step S7 in Fig. 6 corresponds to step S6A in Fig. 5.

According to the present embodiment, step S6B shown in Fig. 6 is performed in the computer, instead of step S6A shown in Fig. 5. In step S6B, it is determined by the CPU whether or not all detection results of chips 2 indicating whether or not each of plurality of chips 2 is mounted at a predetermined position, are prepared. Thereafter, in step S6B, when it is not determined by the CPU that "all detection results of plurality of chips 2 are prepared" (NO in S6B), processing in step S7 is performed, while when it is determined by the CPU that "all detection results of plurality of chips 2 are prepared" (YES in S6B), all the processings are ended. This makes it possible to finish the inspection in a shorter time as compared with Embodiment 1, at the stage where all detection results of individual chips 2 indicating whether or not each of plurality of chips 2 is mounted at the predetermined position, are prepared. Note that in the method of inspecting mounting states of electronic components, which is actually used, step S7 corresponding to step S6A in Fig. 5 is performed subsequently to step S6B, as shown in Fig. 6. This is to prevent the processing for inspection from falling into an infinite loop, when the state where it is not determined that "all detection results of individual chips 2 indicating whether or not each of plurality of chips 2 is mounted at a predetermined position, are prepared", is continued for some reason.

In the following, the cases respectively shown in Fig. 2 and Fig. 4, will be specifically explained. In the case shown in Fig. 2(C), first, the CPU acquires a region corresponding to chip C34 as a chip tentative presence region in the RAM by using threshold value TH1. Next, the CPU acquires regions corresponding to chips C31 and C34 as chip tentative presence regions by using threshold value TH2, and combines the chip tentative presence regions with the old chip tentative presence region corresponding to chip C34. This makes it possible to acquire new chip tentative presence regions corresponding to chips C31 and C34. Next, the CPU acquires regions corresponding to chip C32, C33 and C34 as chip tentative presence regions in the RAM by using threshold value TH3, and combines the chip tentative presence regions with the old chip tentative presence regions corresponding to chip C31 and C34. This makes it possible to acquire regions corresponding to chips C31 to C34 as new chip tentative presence regions. Therefore, in step S6B (third time) after threshold value TH3 is used, it is possible for the CPU to obtain detection results that each of chips C31 to C34 is mounted at a predetermined position.

In the case shown in Fig. 4(C), first, the CPU acquires a region corresponding to chip C14 as a chip tentative presence region by using threshold value TH1. Next, the CPU acquires regions corresponding to chips C11 and C14 as chip tentative presence regions in the RAM by using threshold value TH2, and combines the chip tentative presence regions with the old chip tentative presence region corresponding to chip C14. This makes it possible to acquire the regions corresponding to chips C11 and C14 as new chip tentative presence regions. On the other hand, the CPU recognizes a region corresponding to chip C13 as a chip tentative absence region. Next, the CPU acquires regions corresponding to chips C12 and C14 as chip tentative presence regions in the RAM by using threshold value TH3, and combines the chip tentative presence regions with the old chip tentative presence regions corresponding to chips C11 and C14. This makes it possible to acquire regions corresponding to chips C11, C12 and C14 as new chip tentative presence regions in the RAM. Further, there is no change about the region corresponding to chip C13 acquired as the chip tentative absence region. Therefore, in step S6B (third time) after threshold value TH3 is used, all detection results of individual chips 2 indicating whether or not each of chips C11 to C14 is mounted at a predetermined position, are prepared.

As explained above, according to the present embodiment, it is possible to prepare detection results of individual chips 2 indicating whether or not each of chips C11 to C14 is mounted at a predetermined position, by using only a part of plurality of threshold values TH1 to TH4. Therefore, according to the present embodiment, it is possible to perform inspection of mounting states of chips 2 in a shorter time as compared with Embodiment 1.

Note that the method of inspecting mounting states of electronic components according to the present invention may be used for the purpose of inspecting mounting states of electronic components of different kinds, mounted at predetermined positions of a printed substrate. Here, the electronic components of different kinds may be a plurality of bare chips, a plurality of packages of the electronic components as explained above, and further a mixture of the bare chips and the packages. The electronic components of different kinds may be respectively different in the material, color, reflectance and the like of the upper surface of the components. In this case, it is possible to effectively apply the present invention, because the light beams reflected by the plurality of electronic components are different in luminance from each other, even if an ideal state, that is, a state where respective electronic components are horizontally mounted on the flat printed substrate is assumed.

Further, in the respective embodiments as explained above, lowest threshold value TH1 among plurality of threshold values is used in the first loop, and a predetermined step value is added to the threshold value used in the processing in the loop every time the processing is ended once. Thereby, threshold values TH1, TH2, TH3 and TH4 are gradually increased in this order. However, the method according to the present invention is not limited to this method, and may be adapted such that new threshold values are generated every time a predetermined step value is subtracted from a threshold value which is used first, and the generated threshold values are successively used. In this case, it is preferred that the level of the threshold value used first is set higher.

The relation between the plurality of threshold values to be used may not necessarily be in a relation in which the adjacent threshold values have a difference of a predetermined step value (equal difference). For example, a plurality of threshold values having a relation in which differences between the adjacent threshold values are not equal to each other, may also be used in accordance with a luminance distribution of acquired image information.

Although the present invention has been described and illustrated in detail, it is clearly understood that the same is by way of illustration and example only and is not to be taken by way of limitation, the scope of the present invention being interpreted by the terms of the appended claims.

## Claims

1. A method of inspecting mounting states of electronic components, for inspecting whether or not each of a plurality of electronic components (2) to be mounted at predetermined positions on a substrate (1) is actually mounted at the predetermined position, comprising the steps of:
obtaining image information of the substrate (1) on which the plurality of electronic components (2) are to be mounted;
obtaining binary data by binarizing the image information by using a predetermined threshold value;
obtaining a tentative presence region recognized as corresponding to the electronic component (2) on the basis of the binary data;
setting a new threshold value by changing the predetermined threshold value;
obtaining new binary data by binarizing the image information by using the new threshold value;
setting the new binary data as the binary data in the step of obtaining a tentative presence region;
obtaining new tentative presence regions recognized as corresponding to the plurality of electronic components (2) on the basis of the new binary data; and combining the new tentative presence regions with the tentative presence region,
wherein a loop including the step of setting a new threshold value, the step of obtaining new binary data, the step of setting the new binary data, the step of obtaining new tentative presence regions, and the step of combining the new tentative presence regions, is repeated by a predetermined number of times (N).

2. A method of inspecting mounting states of electronic components, for inspecting whether or not each of a plurality of electronic components (2) to be mounted at predetermined positions on a substrate (1) is actually mounted at the predetermined position, comprising the steps of:
obtaining image information of the substrate (1) on which the plurality of electronic components (2) are to be mounted;
obtaining binary data by binarizing the image information by using a predetermined threshold value;
obtaining a tentative presence region recognized as corresponding to the electronic component (2) on the basis of the binary data;
setting a new threshold value by changing the predetermined threshold value;
obtaining new binary data by binarizing the image information by using the new threshold value;
setting the new binary data as the binary data in the step of obtaining a tentative presence region;
obtaining new tentative presence regions recognized as corresponding to the plurality of electronic components (2) on the basis of the new binary data; and combining the new tentative presence regions with the tentative presence region,
wherein the step of setting a new threshold value, the step of obtaining new binary data, the step of setting the new binary data, the step of obtaining new tentative presence regions; and the step of combining the new tentative presence regions, are repeated until all of detection results of individual chips indicating whether or not each of the plurality of electronic components (2) is mounted at the predetermined position are prepared.

3. The method of inspecting mounting states of electronic components according to one of claim 1 and claim 2,
wherein in the step of setting the new threshold value, the new threshold value is set by increasing or decreasing the threshold value by a predetermined amount.
